# EUROPEAN PATENT SPECIFICATION

(11) **EP 3 932 989 B1**
(45) Date of publication and mention of the grant of the patent: **29.11.2023**
(21) Application number: 21179645.3
(22) Date of filing: 15.06.2021
(51) Int. Cl.: C08L 45/00, G02B 6/122

(54) **BISBENZOCYCLOBUTENE FORMULATIONS**
BISBENZOCYCLOBUTENFORMULIERUNGEN
FORMULATIONS DE BISBENZOCYCLOBUTÈNE

(30) Priority: 02.07.2020 US 202063047444 P
(43) Date of publication of application: 05.01.2022
(73) Proprietor: Rohm and Haas Electronic Materials LLC, Marlborough, MA 01752 (US)
(72) Inventor: GALLAGHER, Michael K., Marlborough, 01752 (US); KONDOH, Masaki, Niigata, 959-1914 (JP); JOO, Jake, Marlborough, 01752 (US); SHEN, Yi, Marlborough, 01752 (US); ZHANG, Zhebin, Marlborough, 01752 (US)
(74) Representative: Houghton, Mark Phillip

(56) References cited:
- US-A1- 2005 117 843
- US-B2- 8 351 752

## Description

### FIELD

The present invention is directed to a composition and a polymeric film made from polymerizing and curing the composition. The polymeric film can be used in optical and electronic devices, and more particularly, in optical waveguides.

### BACKGROUND

Light is becoming increasingly important in the transmission of data and communications. Fiber optic cables, for example, have replaced conventional electrical cables in a number of applications. Guides and switches are needed to capture, carry and distribute the light carrying such transmissions. Optical waveguides typically include a core material and a cladding layer. They operate most efficiently when transmitted light propagates longitudinally in the core material and is contained by the cladding layer which generally has a lower index of refraction than the core material. Next-generation high-end information processing (bandwidths >1 Tb/s and speed >10 Gb/s) is immensely challenging using copper-based interconnects, so polymers are increasingly being used in optical devices such as waveguides.

Polymeric materials offer a number of interesting features for the fabrication of optical waveguides when compared with more-conventional materials. Organic polymers have attracted much attention due to their ease of fabrication and structural flexibility. These are important factors with regard to their use as packaging and optical interconnects. It is also true, however, that polymeric materials may have certain disadvantages. An optical waveguide must retain its optical and physical properties under a variety of environmental conditions including high temperature and high humidity. It must also have the proper optical and surface properties in addition to being economically practical in a given application. When it is intended to prepare an optical waveguide using a resin, film-forming processes required can be conducted by coating and heating operations under atmospheric pressure and accordingly, this method is quite advantageous in that devices and processes to be used are generally simple. Various kinds of resins are known as useful for the constitution of an optical waveguide.

Thermosetting polymers and oligomers made from benzocyclobutene-containing monomers (also referred to as cyclobutarenes) are known to be useful in electronic devices. Commercial examples of such materials based on the 1,3-bis(2-bicyclo[4.2.0]octa 1,3,5-trien-3-yl ethenyl)-1,1,3,3 tetramethylsiloxane (referred to herein as DVS-bisBCB) monomer are available from DuPont under the tradename CYCLOTENE^{™}. Typically, these materials are applied to a substrate by standard coating techniques (e.g. spin coating). They are cured or cross-linked by heating, and they are patterned by etching. Recognition of the desirability of having resins which do not require additional coating steps used in standard lithographic etching has led to the development of CYCLOTENE 4000 resins, which are negative tone photosensitive compositions, in which the portion of the material which is not exposed to the activating radiation is removed by solvent during development. After patterning, the remaining resin is cured. Another among the CYCLOTENE product line, the 6000 series, have demonstrated effectiveness as photo-defined spin-on materials for high-resolution applications using aqueous base developers such as 0.26N TMAH.

However, it can sometimes be difficult to identify the ideal processing conditions in materials such as these that allow a balance, for example, of the surface roughness and unexposed film thickness loss (UFTL) required for optimum performance in optical applications such as waveguides. Generally, these devices require the achievement of low surface roughness and low UFTL at the same time in a single material. This can be difficult to achieve in practice with incumbent materials and formulations. One or more of several approaches is generally attempted. The resin composition or solids content may be adjusted; or the processing parameters such as soft-bake temperature, spin speed, developing time, and others can be modified. US2005/117843A1 discloses a process for fabricating optical waveguides with complex integrated devices such as gratings. US8351752B2 discloses a flexible optical waveguide prepared by using a resin film for forming an optical waveguide for at least one of a lower cladding layer, a core layer and an upper cladding layer, wherein a ten point average roughness (Rz) on a surface of either one of the lower cladding layer and the upper cladding layer is 0.5 mum or more and 10 mum or less, a production process for the same and an optical module prepared by using the flexible optical waveguide.

There is thus an ongoing need for new polymeric materials, compositions, and associated processes suited for use in optical devices such as waveguides.

### BRIEF DESCRIPTION OF THE DRAWINGS

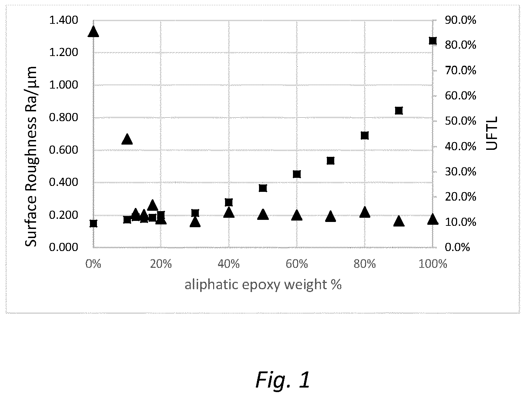

Fig. 1 illustrates film surface roughness (Rₐ, ▲) and unexposed film thickness loss (UFTL, ■) as a function of epoxy content for films prepared from the compositions disclosed herein.

### DETAILED DESCRIPTION

As used throughout this specification, the following abbreviations shall have the following meanings, unless the context clearly indicates otherwise: °C = degree Celsius; g = gram; nm = nanometer, µtm = micron = micrometer; mm = millimeter; sec. = second; min. = minutes; hr. = hours; L = liter; mL = milliliter; MPa = megapascal; M_{w} = weight average molecular weight; Mₙ = number average molecular weight; and ANW = atomic mass unit. All amounts are percent by weight ("wt%") and all ratios are molar ratios, unless otherwise noted. All numerical ranges are inclusive and combinable in any order, except where it is clear that such numerical ranges are constrained to added up to 100%. Unless otherwise noted, all polymer and oligomer molecular weights are weight average molecular weights ('Mw") and are determined using gel permeation chromatography compared to polystyrene standards.

The articles "a," "an," and "the" refer to the singular and the plural, unless the context clearly indicates otherwise. As used herein, the term "and/or" includes any and all combinations of one or more of the associated items. The term "alkyl" includes linear, branched and cyclic alkyl. Likewise, "alkenyl" refers to linear, branched and cyclic alkenyl. "Aryl" refers to aromatic carbocycles and aromatic heterocycles. As used herein, the term "aliphatic" refers to an open-chain carbon-containing moiety, such as alkyl, alkenyl and alkynyl moieties, which may be linear or branched. Also as used herein, the term "alicyclic" refers to a cyclic aliphatic moiety, such as cycloalkyl and cycloalkenyl. Such alicyclic moieties are non-aromatic, but may include one or more carbon-carbon double bonds. As used herein, the term "deuterated" is intended to mean that at least one hydrogen ("H") has been replaced by deuterium ("D"). The term "deuterated analog" refers to a structural analog of a compound or group in which one or more available hydrogens have been replaced with deuterium. In a deuterated compound or deuterated analog, the deuterium is present in at least 100 times the natural abundance level. "Halo" refers to fluoro, chloro, bromo, and iodo. The term "(meth)acrylate" refers to both methacrylate and acrylate, and likewise the term (meth)acrylamide refers to both methacrylamide and acrylamide. Unless the context clearly indicates otherwise, by "substituted" alkyl, alkenyl, or alkynyl is meant that one or more hydrogens on the alkyl, alkenyl, or alkynyl is replaced with one or more substituents chosen from deuterium, halo, hydroxy, C₁₋₁₀ alkoxy, amino, mono- or di-C₁₋₁₀ hydrocarbyl substituted amino, C₅₋₂₀ aryl, and substituted C₅₋₂₀ aryl. Unless the context clearly indicates otherwise, by "substituted" aryl is meant that one or more hydrogens on the aryl is replaced by one or more substituents chosen from deuterium, halo, hydroxy, C₁₋₁₀ alkyl, C₂₋₁₀ alkenyl, C₂₋₁₀ alkynyl, C₁₋₁₀ alkoxy, amino, mono- or di-C₁₋₁₀ hydrocarbyl substituted amino, C₅₋₂₀ aryl, and substituted C₅₋₂₀ aryl. "Alkyl" refers to an alkane radical and includes alkane diradicals (alkylene) and higher-radicals. Likewise, the terms "alkenyl", "alkynyl" and "aryl" refer to the corresponding mono-, di- or higher-radicals of an alkene, alkyne and arene, respectively.

By the term "curing" is meant any process, such as polymerization or condensation, that increases the molecular weight of a material or composition. "Curable" refers to any material capable of being cured under certain conditions. The term "polymer" also includes oligomers. The term "oligomer" refers to relatively low molecular weight materials such as dimers, trimers, tetramers, pentamers, hexamers, and the like, including B-staged material, that are capable of further curing. As used herein, "aromatic organic residue" embraces an organic residue that has only aromatic character, such as phenyl, as well as an organic residue that contains a combination of aromatic and aliphatic moieties. All amounts are percent by weight and all ratios are molar ratios, unless otherwise noted.

It will be understood that although the terms first, second, third, etc. may be used herein to describe various elements, components, regions, layers and/or sections, these elements, components, regions, layers, and/or sections should not be limited by these terms. These terms are only used to distinguish one element, component, region, layer or section from another element, component, region, layer or section. Thus, a first element, component, region, layer or section could be termed a second element, component, region, layer or section without departing from the teachings of the present invention. Similarly, the terms "top" and "bottom" are only relative to each other. It will be appreciated that when an element, component, layer or the like is inverted, what was the "bottom" before being inverted would be the "top" after being inverted, and vice versa. When an element is referred to as being "on" or "disposed on" another element, it can be directly on the other element or intervening elements may be present therebetween. In contrast, when an element is referred to as being "directly on" or "disposed directly on" another element, there are no intervening elements present.

The present invention provides a composition comprising: (a) one or more curable cyclobutarene-based polymers or oligomers comprising acid functional pendant groups; (b) one or more aromatic epoxy compounds comprising a mixture of glycidyl ethers of aromatic phenols; (c) one or more aliphatic epoxy compounds; and (d) one or more photoactive compounds.

In one non-limiting embodiment the acid functional pendant groups are present at equivalent weights of about 100 to about 400 g/mole of acid functionality, in one non-limiting embodiment about 150 to about 375 g/mole of acid functionality, and in one non-limiting embodiment about 200 to about 350 g/mole of acid functionality.

In one non-limiting embodiment, the one or more curable cyclobutarene-based polymers or oligomers comprises as polymerized units one or more arylcyclobutene first monomers and one or more second monomers having one or more acid moieties chosen from carboxylic acid, protected carboxylic acid, and sulfonic acid.

In one non-limiting embodiment, the one or more arylcyclobutene first monomers has formula (1): 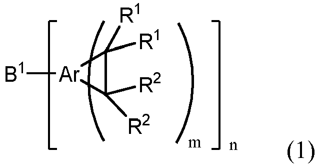 wherein B¹ is an n-valent linking group; Ar is a polyvalent aryl group and the carbon atoms of the cyclobutene ring are bonded to adjacent carbon atoms on the same aromatic ring of Ar; m is an integer of 1 or more; n is an integer of 1 or more; each of R¹ and R² is independently a monovalent group; the two R¹ moieties may be taken together along with the carbon to which they are attached to form a carbonyl or thiocarbonyl; and the two R² moieties may be taken together along with the carbon to which they are attached to form a carbonyl or thiocarbonyl. In one non-limiting embodiment, the polyvalent aryl group, Ar, may be composed of 1 to 3 aromatic carbocyclic, heteroaromatic rings, deuterated aromatic carboxylic, or deuterated heteroaromatic. In some non-limiting embodiment, Ar is deuterated. In one non-limiting embodiment the aryl group comprises a single aromatic ring, and one non-limiting embodiment a phenyl ring. When Ar is a phenyl ring, the monomer is a benzocyclobutene (BCB) monomer. The aryl group is optionally substituted with 1 to 3 groups chosen from C₁₋₆ alkyl, tri-C₁₋₆-alkylsilyl, C₁₋₆ alkoxy, deuterated C₁₋₆ alkyl, deuterated tri-C₁₋₆-alkylsilyl, deuterated C₁₋₆ alkoxy, halo, and carboxyl. In one non-limiting embodiment, the aryl group is optionally substituted with one or more of D, C₁₋₆ alkyl, tri-C₁₋₃-alkylsilyl, C₁₋₃ alkoxy, deuterated C₁₋₆ alkyl, deuterated tri-C₁₋₃-alkylsilyl, deuterated C₁₋₃ alkoxy, chloro, bromo, fluoro, and carboxyl. In one non-limiting embodiment, the aryl group is optionally substituted with one or more of C₁₋₃ alkyl, tri-C₁₋₃-alkylsilyl, C₁₋₃ alkoxy, deuterated C₁₋₃ alkyl, deuterated tri-C₁₋₃-alkylsilyl, deuterated C₁₋₃ alkoxy, and carboxyl. In one non-limiting embodiment, the aryl group is unsubstituted or substituted with carboxyl. In one non-limiting embodiment n = 1 or 2, and in one non-limiting embodiment n = 1. In one non-limiting embodiment m = 1-4, in another non-limiting embodiment m = 2-4, and in one non-limiting embodiment m = 2.

Each R¹ and R² may be independently chosen from H, D, C₁₋₆ alkyl, C₁₋₆ alkenyl, C₁₋₆ alkoxy, carboxy, C₂₋₆ carboxy-containing moiety, C₂₋₆ keto-containing moiety, C₁₋₆ amido-containing moiety, C₂₋₆ alkoxyalkanol, C₂₋₆ alkoxyester, deuterated C₁₋₆ alkyl, deuterated C₁₋₆ alkenyl, deuterated C₁₋₆ alkoxy, deuterated C₂₋₆ carboxy-containing moiety, deuterated C₂₋₆ keto-containing moiety, deuterated C₁₋₆ amido-containing moiety, deuterated C₂₋₆ alkoxyalkanol, deuterated C₂₋₆ alkoxyester, and halo. In some non-limiting embodiments, each R¹ and R² may be independently chosen from H, D, C₁₋₃ alkyl, C₁₋₃ alkoxy, deuterated C₁₋₃ alkyl, deuterated C₁₋₃ alkoxy, and halo. In one non-limiting embodiment suitable single-valent B¹ groups have the formula -[C(R³)₂-C(R⁴)₂]ₓZ¹ or -[C(R³)=CR⁴]ₓZ¹, wherein each R³ and R⁴ are independently chosen from hydrogen, deuterium, C₁₋₆ alkyl and aryl, deuterated C₁₋₆ alkyl and aryl; Z is chosen from hydrogen, deuterium, C₁₋₆ alkyl, C₆₋₁₀ aryl, siloxaryl, siloxyalkyl, deuterated C₁₋₆ alkyl, deuterated C₆₋₁₀ aryl, deuterated siloxaryl, deuterated siloxyalkyl, and -CO₂R⁵; each R⁵ is independently chosen from H, D, C₁₋₆ alkyl, C₁₋₆ hydroxyalkyl, C₆₋₁₀ aryl, C₆₋₁₀ hydroxyaryl, C₇₋₂₀ aralkyl, C₇₋₂₀ hydroxyaralkyl, C₇₋₂₀ alkaryl, deuterated C₁₋₆ alkyl, deuterated C₁₋₆ hydroxyalkyl, deuterated C₆₋₁₀ aryl, deuterated C₆₋₁₀ hydroxyaryl, deuterated C₇₋₂₀ aralkyl, deuterated C₇₋₂₀ hydroxyaralkyl, and deuterated C₇₋₂₀ alkaryl; and x = 1 or 2. In one non-limiting embodiment, R³ and R⁴ are independently chosen from H, D, C₁₋₃ alkyl, aryl, deuterated C₁₋₃ alkyl, deuterated aryl and in one non-limiting embodiment H, D, C₁₋₃ alkyl, and deuterated C₁₋₃ alkyl. In one non-limiting embodiment, R⁵ is selected from the group consisting of H, D, C₁₋₃ alkyl, C₁₋₆ hydroxyalkyl, C₆₋₁₀ aryl, C₆₋₁₀ hydroxyaryl, C₇₋₂₀ hydroxyaralkyl, deuterated C₁₋₃ alkyl, deuterated C₁₋₆ hydroxyalkyl, deuterated C₆₋₁₀ aryl, deuterated C₆₋₁₀ hydroxyaryl, and deuterated C₇₋₂₀ hydroxyaralkyl. In one non-limiting embodiment, Z¹ is siloxyl, deuterated siloxyl or - CO₂R⁵. Siloxyl groups generally have the formula -[Si(R⁶)₂-O]p-Si(R⁶)₂-, wherein each R⁶ is independently chosen from H, D, C₁₋₆ alkyl, aryl, aralkyl, alkaryl, deuterated C₁₋₆ alkyl, deuterated aryl, deuterated aralkyl, and deuterated alkaryl; and p is an integer greater than or equal to 1. In one non-limiting embodiment, R⁶ is chosen from C₁₋₃ alkyl, C₆₋₁₀ aryl, C₇₋₂₀ aralkyl, deuterated C₁₋₃ alkyl, deuterated C₆₋₁₀ aryl, and deuterated C₇₋₂₀ aralkyl. Suitable aralkyl groups include benzyl, phenethyl and phenylpropyl, and deuterated versions thereof. In some non-limiting embodiments, B¹ comprises one or more carbon-carbon double bonds (ethylenic unsaturation).

The synthesis and properties of these cyclobutarenes, as well as terms used to describe them, may be found, for example, in U.S. Patents 4,540,763; 4,724,260; 4,783,514; 4,812,588; 4,826,997; 4,999,499; 5,136,069; 5,185,391; 5,243,068.

In some non-limiting embodiments, the one or more arylcyclobutene first monomers comprises as polymerized units one or more bis-benzocyclobutene monomers of formula (2): 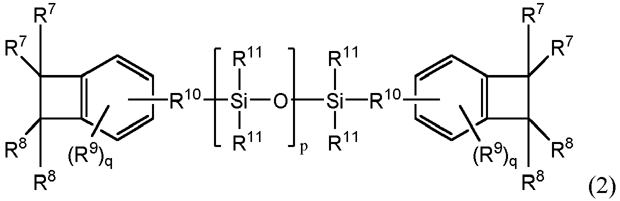 wherein each R⁷ and R⁸ is independently chosen from H, D, C₁₋₆ alkyl, C₁₋₆ alkenyl, C₁₋₆ alkoxy, deuterated C₁₋₆ alkyl, deuterated C₁₋₆ alkenyl, deuterated C₁₋₆ alkoxy, halo, carboxy, C₂₋₆ carboxy-containing moiety, deuterated C₂₋₆ carboxy-containing moiety, C₂₋₆ keto-containing moiety, deuterated C₂₋₆ keto-containing moiety, C₁₋₆ amido-containing moiety, deuterated C₁₋₆ amido-containing moiety, C₂₋₆ alkoxyalkanol, deuterated C₂₋₆ alkoxyalkanol, C₂₋₆ alkoxyester, deuterated C₂₋₆ alkoxyester, -O-C₁₋₂₀ alkyl, -(C=O)-C₁₋₂₀ alkyl, -O-(C=O)-C₁₋₂₀ alkyl, -(C=O)-O-C₁₋₂₀ alkyl, -O-C₆₋₂₀ aryl, -(C=O)-C₆₋₂₀ aryl, -O-(C=O)-C₆₋₂₀ aryl, -(C=O)-O-C₆₋₂₀ aryl, deuterated -O-C₁₋₂₀ alkyl, deuterated -(C=O)-C₁₋₂₀ alkyl, deuterated -O-(C=O)-C₁₋₂₀ alkyl, deuterated - (C=O)-O-C₁₋₂₀ alkyl, deuterated -O-C₆₋₂₀ aryl, deuterated -(C=O)-C₆₋₂₀ aryl, deuterated -O-(C=O)-C₆₋₂₀ aryl, and deuterated -(C=O)-O-C₆₋₂₀ aryl. In one non-limiting embodiment, each R⁷ and R⁸ is independently chosen from H, D, C₁₋₃ alkyl, C₁₋₃ alkoxy, deuterated C₁₋₃ alkyl, deuterated C₁₋₃ alkoxy, and halo; wherein the two R⁷ moieties may be taken together along with the carbon to which they are attached to form a carbonyl, thiocarbonyl, or deuterated versions thereof; and wherein the two R⁸ moieties may be taken together along with the carbon to which they are attached to form a carbonyl, thiocarbonyl, or deuterated versions thereof; each R⁹ is independently chosen from H, D, C₁₋₆ alkyl, tri-C₁₋₆-alkylsilyl, C₁₋₆ alkoxy, deuterated C₁₋₆ alkyl, deuterated tri-C₁₋₆-alkylsilyl, deuterated C₁₋₆ alkoxy, and halo; each R¹⁰ is independently a divalent organic group which may be saturated or ethylenically unsaturated; each R¹¹ is independently chosen from H, D, C₁₋₆ alkyl, C₇₋₂₀ aralkyl, phenyl, deuterated C₁₋₆ alkyl, deuterated C₇₋₂₀ aralkyl and deuterated phenyl; p is an integer from 1 or more; and q is an integer from 0 to 3. In one non-limiting embodiment, each R⁷ and R⁸ independently chosen from H, D, C₁₋₃ alkyl, C₁₋₃ alkoxy, deuterated C₁₋₃ alkyl, and deuterated C₁₋₃ alkoxy and in one non-limiting embodiment each R⁷ and R⁸ is H. In one non-limiting embodiment, each R⁹ is independently chosen from C₁₋₆ alkyl, tri-C₁₋₃-alkylsilyl, C₁₋₃ alkoxy, deuterated C₁₋₆ alkyl, deuterated tri-C₁₋₃-alkylsilyl, deuterated C₁₋₃ alkoxy, and chloro, and in one non-limiting embodiment from C₁₋₃ alkyl, tri-C₁₋₃-alkylsilyl, C₁₋₃ alkoxy, deuterated C₁₋₃ alkyl, deuterated tri-C₁₋₃-alkylsilyl, and deuterated C₁₋₃ alkoxy. In one non-limiting embodiment, each R¹⁰ is independently chosen from C₂₋₆ alkyl, C₂₋₆ alkenyl, C₂₋₆ alkynyl, and deuterated versions thereof, and in one non-limiting embodiment, each R¹⁰ is independently chosen from -CH₂CH₂-, -CH=CH-, and -C=C-, wherein one or more H may be replaced by D. In one non-limiting embodiment, each R¹¹ is chosen from C₁₋₃ alkyl and deuterated C₁₋₃ alkyl and in one non-limiting embodiment each R¹¹ is methyl or deuterated methyl. In one non-limiting embodiment, p = 1-5; in another non-limiting embodiment, p = 1-3; and in another non-limiting embodiment, p = 1. In one non-limiting embodiment, q = 3. In one non-limiting embodiment, the arylcyclobutene monomer of formula (2) is 1,3-bis(2-bicyclo[4.2.0]octa-1,3,5-trien-3-yl-ethenyl)-1,1,3,3-tetramethyldisiloxane (DVS-bisBCB), which has the formula (3):

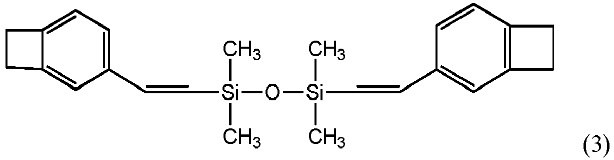

In some non-limiting embodiments, the present arylcyclobutene polymers comprise as polymerized units one or more arylcyclobutene first monomers and one or more second monomers having one or more acid moieties chosen from carboxylic acid, protected carboxylic acid, and sulfonic acid of formula (4): 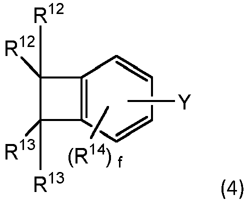 wherein each R¹² and R¹³ is independently chosen from H, D, C₁₋₆ alkyl, C₁₋₆ alkenyl, C₁₋₆ alkoxy, deuterated C₁₋₆ alkyl, deuterated C₁₋₆ alkenyl, deuterated C₁₋₆ alkoxy, halo, carboxy, C₂₋₆ carboxy-containing moiety, C₂₋₆ keto-containing moiety, C₁₋₆ amido-containing moiety, C₂₋₆ alkoxyalkanol, C₂₋₆ alkoxyester, -O-C₁₋₂₀ alkyl, -(C=O)-C₁₋₂₀ alkyl, -O-(C=O)-C₁₋₂₀ alkyl, - (C=O)-O-C₁₋₂₀ alkyl, -O-C₆₋₂₀ aryl, -(C=O)-C₆₋₂₀ aryl, -O-(C=O)-C₆₋₂₀ aryl, -(C=O)-O-C₆₋₂₀ aryl, deuterated C₂₋₆ carboxy-containing moiety, deuterated C₂₋₆ keto-containing moiety, deuterated C₁₋₆ amido-containing moiety, deuterated C₂₋₆ alkoxyalkanol, deuterated C₂₋₆ alkoxyester, deuterated -O-C₁₋₂₀ alkyl, deuterated -(C=O)-C₁₋₂₀ alkyl, deuterated -O-(C=O)-C₁₋₂₀ alkyl, deuterated -(C=O)-O-C₁₋₂₀ alkyl, deuterated -O-C₆₋₂₀ aryl, deuterated -(C=O)-C₆₋₂₀ aryl, deuterated -O-(C=O)-C₆₋₂₀ aryl, and deuterated -(C=O)-O-C₆₋₂₀ aryl. In some non-limiting embodiments each R¹² and R¹³ is independently chosen from H, D, C₁₋₃ alkyl, C₁₋₃ alkoxy deuterated C₁₋₃ alkyl, and deuterated C₁₋₃ alkoxy ; wherein the two R¹² moieties may be taken together along with the carbon to which they are attached to form a carbonyl, thiocarbonyl, or deuterated versions thereof; and wherein the two R¹³ moieties may be taken together along with the carbon to which they are attached to form a carbonyl, thiocarbonyl, or deuterated versions thereof; each R¹⁴ is independently chosen from H, D, C₁₋₆ alkyl, tri-C₁₋₆-alkylsilyl, C₁₋₆ alkoxy, deuterated C₁₋₆ alkyl, deuterated tri-C₁₋₆-alkylsilyl, deuterated C₁₋₆ alkoxy, and halo; Y is - SO₃R¹⁵ or a monovalent radical having from 3 to 15 carbon atoms and having at least one -OH moiety or a protected carboxyl moiety; R¹⁵ is H, D or a monovalent radical having from 1 to 20 carbon atoms; and f is an integer of from 0 to 2. In some non-limiting embodiments, each R¹² and R¹³ is independently chosen from H, D, C₁₋₃ alkyl, C₁₋₃ alkoxy, deuterated C₁₋₃ alkyl, deuterated C₁₋₃ alkoxy and halo, and in some non-limiting embodiments each R¹² and R¹³ is H or D. In some non-limiting embodiments, each R¹⁴ is independently chosen from C₁₋₆ alkyl, tri-C₁₋₃-alkylsilyl, C₁₋₃ alkoxy, deuterated C₁₋₆ alkyl, deuterated tri-C₁₋₃-alkylsilyl, deuterated C₁₋₃ alkoxy, and chloro, and in some non-limiting embodiments from C₁₋₃ alkyl, tri-C₁₋₃-alkylsilyl, C₁₋₃ alkoxy, deuterated C₁₋₃ alkyl, deuterated tri-C₁₋₃-alkylsilyl, and deuterated C₁₋₃ alkoxy. The monovalent radical of Y may be aliphatic and/or aromatic. Typically, Y has from 1 to 5 -OH moieties, in some non-limiting embodiments from 1 to 3, in some non-limiting embodiments 1 or 2, and in some non-limiting embodiments 1 -OH moiety. Y may be a saturated or unsaturated monovalent radical having from 3 to 15 carbon atoms and having at least one -OH moiety and is preferably ethylenically unsaturated. In some non-limiting embodiments, the at least one -OH moiety of Y is -CO₂H or -SO₃H. In some non-limiting embodiments R¹⁵ is H, D, a C₁₋₁₀ alkyl, C₇₋₁₆ aralkyl, C₆₋₁₂ aryl, or deuterated versions thereof. In some non-limiting embodiments of formula (4) Y is chosen from -CH=CHC(=O)OR¹⁶; -CH=CH-CH₂OH; -CH₂-CH=CHC₆H₄OH; - CH=CHCH₂C₆H₄OH; and deuterated versions thereof wherein R¹⁶ is chosen from H, D, C₂₋₈ hydroxyalkyl, C₄₋₈ alkyl, deuterated C₂₋₈ hydroxyalkyl, and deuterated C₄₋₈ alkyl having one or more quaternary carbons directly bonded to the oxygen of the carboxyl moiety. In some non-limiting embodiments, compounds of formula (4) are those wherein Y is -CH=CHC(=O)OR¹⁶, and in some non-limiting embodiments -CH=CHC(=O)OH. In some non-limiting embodiments f=3.

The present arylcyclobutene polymers may comprise as polymerized units one arylcyclobutene monomer or more than one arylcyclobutene monomers. In some non-limiting embodiments, the present polymers comprise as polymerized units two distinct arylcyclobutene monomers. In some non-limiting embodiments, the present arylcyclobutene polymer comprises as polymerized units one or more arylcyclobutene monomers comprising one or more moieties chosen from carboxylic acid, protected carboxylic acid and sulfonic acid. In some non-limiting embodiments, the present arylcyclobutene polymers comprise as polymerized units one or more bisbenzocyclobutene monomers of formula (2) and one or more monomers of formula (4), and in some non-limiting embodiments the monomer of formula (3) and one or more monomers of formula (4).

In one non-limiting embodiment, the one or more second monomers having one or more acid moieties chosen from carboxylic acid, protected carboxylic acid, and sulfonic acid is given by formula (5): 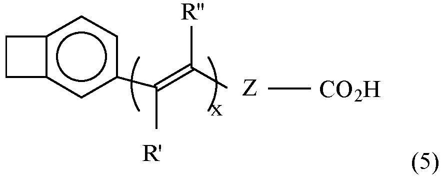 wherein in some non-limiting embodiments, the benzocyclobutene comprises one or more deuterium atoms; wherein R' and R" are independently selected from hydrogen, deuterium, alkyl or deuterated groups of 1 to 6 carbon atoms, aryl groups or deuterated aryl groups, or R' and R" taken together from a cyclic group of 4 to 8 carbon atoms; Z is a carbon-carbon bond or an aryl group; and x is an integer from 0 to 3. In some non-limiting embodiments, x is 1.

In one non-limiting embodiment, the one or more second monomers having one or more acid moieties chosen from carboxylic acid, protected carboxylic acid, and sulfonic acid is given by formula (6): 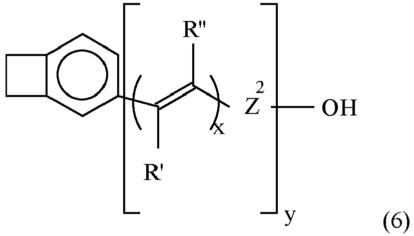 wherein in some non-limiting embodiments, the benzocyclobutene comprises one or more deuterium atoms; wherein R' and R" are as defined above; x is 1; y is 0 or 1; and Z² is an aryl group.

In one non-limiting embodiment, the one or more second monomers having one or more acid moieties chosen from carboxylic acid, protected carboxylic acid, and sulfonic acid may be synthesized by well-known Heck chemistry - that is, a Palladium catalyzed coupling of a halogenated-cyclobutarene with a vinyl functional hydroxy containing compound. See for example, U.S. 5,243,068. However, if x = 0, the second monomer may be synthesized by a Grignard reaction of a benzocyclobutene with carbon dioxide or by carbonylation of benzocyclobutene followed by hydrolysis. See U.S. 5,277,536. If y = 0, the second monomer may be synthesized by heating a halogenated cyclobutene with sodium hydroxide.

In one non-limiting embodiment, the one or more curable cyclobutarene-based polymers or oligomers comprising as polymerized units one or more arylcyclobutene first monomers and one or more second monomers having one or more acid moieties chosen from carboxylic acid, protected carboxylic acid, and sulfonic acid may be partially polymerized, in solvent or optionally neat, to form an oligomer or prepolymer that may then be used in aqueous base developed imaging systems such as wet etch and photosensitive systems. In one non-limiting embodiment, polymerization occurs at a temperature in the range of about 125 to about 300°C, in one non-limiting embodiment about 130 to about 250°C. The polymerization may occur for a time determined to provide a partially polymerized resin that provides the desired finally cured film properties. In one non-limiting embodiment, the curable product has an apparent weight average molecular weight (Mw) as determined by Gas Permeation Chromatography (GPC) in the range of about 1000 to about 50,000 g/mol, in one non-limiting embodiment about 1500 to about 25,000 g/mol, and in one non-limiting embodiment about 2000 to about 15,000 g/mol.

In one non-limiting embodiment, the one or more curable cyclobutarene-based polymers or oligomers comprising as polymerized units one or more arylcyclobutene first monomers and one or more second monomers having one or more acid moieties chosen from carboxylic acid, protected carboxylic acid, and sulfonic acid; the molar ratio of the cyclobutarene component to the dienophilic component is about 20:80 to about 70:30, in one non-limiting embodiment about 25:75 to about 50:50, and in one non-limiting embodiment about 25:75 to about 40:60.

Suitable solvents for the one or more curable cyclobutarene-based polymers or oligomers comprising as polymerized units one or more arylcyclobutene first monomers and one or more second monomers having one or more acid moieties chosen from carboxylic acid, protected carboxylic acid, and sulfonic acid include those that dissolve the reacting monomers at the relevant processing temperature. In one non-limiting embodiment, the solvent also dissolves partially-polymerized resin. Examples of such solvents include aromatic hydrocarbons such as toluene, xylene and mesitylene; C₃-C₆ alcohols; methylcyclohexanone; N-methylpyrrolidinone; butyrolactone; dipropylene glycol dimethyl ether isomers (commercially available from The Dow Chemical Company as Proglyde^{™} DMM); and Dowanol^{™} DPMA ((di(propylene glycol) methyl ether acetate isomers available from The Dow Chemical Company).

While not wishing to be bound by theory, the partially polymerized materials may be formed by a reaction such as that disclosed in Kirchoff and Bruza, Progress in Polymer Science, 18, p. 85 and following (1993); Farona, Benzocyclocutenes in Polymer Chemistry, Progress in Polymer Science, 21, p. 505 and following (1996); Marks et al., BCB Homopolymerization Chemistry and Applications, The Polymeric Materials Encyclopedia, Salamone, ed., CRC Press, June 1996; and Hahn et al., Thermal Polymerization of Bis(benzocyclobutene) Monomers containing alpha, beta-disubstituted Ethenes, Macromolecules, 26, 15, pp. 3870-3877, 1993.

In one non-limiting embodiment of the composition disclosed herein, the composition additionally comprises one or more aromatic epoxy resins comprising a mixture of glycidyl ethers of aromatic phenols. While not wishing to be bound by theory, aromatic epoxy resins are generally more rigid, have higher softening points, and may in turn lead to a decrease in tetramethylammonium hydroxide (TMAH) solubility during the development step. Typical aromatic epoxy resins include trihydroxy phenylmethane type epoxy resins, such as Mitsubishi Chemical Corporation jER1032-S50/H60, Nippon Kayaku Co., Ltd. EPPN-501/502H, Huntsman Tactix 742/743 and DIC N-540/541; dicyclopentadiene aralkyl type epoxy resins, such as DIC Corporation Epiclon HP-7200L, (dicyclopentadiene skeleton containing polyfunctional solid epoxy resin); Novolak-type epoxy resins, such as biphenyl aralkyl type epoxy resin, Nippon Kayaku Co., Ltd. NC-3000/NC-3000L/NC3500 (Biphenyl skeleton containing polyfunctional solid epoxy resin), DIC Corporation Epiclon N660, Epiclon N690, and Nippon Kayaku Co., Ltd. EOCN-104S; biphenyl type epoxy resin, such as Mitsubishi Chemical Corporation YX-4000HK and YL-6121H; naphthalene type epoxy resins, such as DIC Corporation HP-4700 / HP-4710 (tetrafunctional naphthalene type epoxy resin), DIC Corporation HP-6000 (naphthylene ethertype epoxy resin), Nippon Kayaku Co., Ltd. NC-7000L / NC7300L, ESN-475V/ESN-375/ESN-170/ESN-480 by Nippon-Steel-Chemical company (naphthol type epoxy resin); tris (2, 3-epoxypropyl) isocyanurate; phosphorus-containing epoxy resins, such as TX0712 by the Nippon Steel & Sumikin Chemical company, TEPIC by Nissan Chemical Industries, Ltd.; and the solid bis-phenol A-type epoxy resin of Mitsubishi Chemical Corporation YL6810. Other suitable aromatic epoxy resins would generally be known to one having skill in the art based on this non-limiting list.

In one non-limiting embodiment of the composition disclosed herein, the composition additionally comprises one or more aliphatic epoxy compounds that are more generally liquid epoxy resins at normal temperature (for example, 20°C). These tend to be more flexible than aromatic epoxy resins and may therefore increase the TMAH solubility during development. In some non-limiting embodiments, these aliphatic resins have one or more epoxy groups. In some non-limiting embodiments, these aliphatic resins have two or more epoxy groups. In some non-limiting embodiments, these aliphatic resins have three or more epoxy groups. Specific, non-limiting embodiments of aliphatic resins including up to three epoxy groups include: a cyclohexane dimethanol epoxy resin, such as Lanxess RD111; a neopentyl glycol diglycidyl ether, such as Lanxess RD114LE; a dicyclopentadiene type epoxy resin; a hydrogenated epoxy resin, such as Mitsubishi Chemical Corporation, YX8000/8034/8040/6753/6800; a cycloaliphatic epoxy resin, such as Mitsubishi Chemical Corporation, E171D or Daicel ChemTech Inc, 2021P/2000/2081/ 3000/8000/8010; a polyol type epoxy resin; an aliphatic ester epoxy resin, such as Daicel ChemTech Inc, Epolead GT301/GT401 or Nippon Kayaku Co Ltd. AK-601; and monofunctional reactive diluent types, such as marketed by ADEKA, Lanxess, Nagase, Olin, Rachig, or Sakamoto Yukahin. Other suitable aliphatic epoxy resins would generally be known to one having skill in the art based on this non-limiting list.

The invention of the present disclosure also includes one or more curing agents, and a variety of such curing agents may be used. In one non-limiting embodiment, the curing agent is a photoactive compound that is activated by light. In one non-limiting embodiment, the curing agent is a thermally-active compound that is activated by heat. Exemplary curing agents include, but are not limited to, thermally-generated initiators and photoactive compounds (photogenerated initiators). The selection of such curing agents is within the ability of those skilled in the art. In one non-limiting embodiment, thermal-generated initiators are free radical initiators, such as, but not limited to, azobisisobutyronitrile, dibenzoyl peroxide, and dicumylperoxide. In one non-limiting embodiment, photoactive curing agents are free-radical photoinitiators available from BASF under the Irgacure brand, and diazonaphthoquinone (DNQ) compounds, including sulfonate esters of a DNQ compound. Suitable DNQ compounds are any compounds having a DNQ moiety, such as a DNQ sulfonate ester moiety, and that function as photoactive compounds in the present compositions, that is, they function as dissolution inhibitors upon exposure to appropriate radiation. Suitable DNQ compounds are disclosed in U.S. Pat. Nos. 7,198,878 and 8,143,360.

In some non-limiting embodiments of the composition comprising: (a) one or more curable cyclobutarene-based polymers or oligomers comprising acid functional pendant groups, (b) one or more aromatic epoxy compounds comprising a mixture of glycidyl ethers of aromatic phenols, (c) one or more aliphatic epoxy compounds, and (d) one or more photoactive compounds; the one or more cyclobutarene-based polymers or oligomers comprising acid functional pendant groups are present in an amount of 20 to 80 wt%, based on the total solid composition of the formulation. In some non-limiting embodiments 30 to 75 wt%, in some non-limiting embodiments 5 to 40 wt%, in some non-limiting embodiments 40 to 70 wt%, and in some non-limiting embodiments 60 wt%.

In some non-limiting embodiments of the composition comprising: (a) one or more curable cyclobutarene-based polymers or oligomers comprising acid functional pendant groups, (b) one or more aromatic epoxy compounds comprising a mixture of glycidyl ethers of aromatic phenols, (c) one or more aliphatic epoxy compounds, and (d) one or more photoactive compounds; the total amount of the epoxy compounds are present in an amount of 10 to 40 wt%, %, based on the total solid composition of the formulation. In some non-limiting embodiments 15 to 35 wt%, and in some non-limiting embodiments 20 to 25 wt%.

In some non-limiting embodiments of the composition comprising: (a) one or more curable cyclobutarene-based polymers or oligomers comprising acid functional pendant groups, (b) one or more aromatic epoxy compounds comprising a mixture of glycidyl ethers of aromatic phenols, (c) one or more aliphatic epoxy compounds, and (d) one or more photoactive compounds; the relative wt% of aliphatic epoxy compound to the total epoxy loading is 1 to 99%. In some non-limiting embodiments 5 to 80%, in some non-limiting embodiments 10 to 60%, and in some non-limiting embodiments 11 to 40%.

In some non-limiting embodiments of the composition comprising: (a) one or more curable cyclobutarene-based polymers or oligomers comprising acid functional pendant groups, (b) one or more aromatic epoxy compounds comprising a mixture of glycidyl ethers of aromatic phenols, (c) one or more aliphatic epoxy compounds, and (d) one or more photoactive compounds; the one or more photoactive compounds are present in an amount of 1 to 25 wt%, based on the total solid composition of the formulation. In some non-limiting embodiments 2 to 20 wt%, in some non-limiting embodiments 4 to 18 wt%, in some non-limiting embodiments 6 to 16 wt%, and in some non-limiting embodiments about 15 wt%.

The present invention further provides a composition comprising the composition as disclosed herein and one or more organic solvents. Suitable organic solvents are those in which the present polymers and compositions are soluble. Particularly useful organic solvents are any solvents useful in the manufacture or formulation of arylcyclobutene polymers. Exemplary organic solvents include, without limitation: aromatic hydrocarbons such as anisole (methoxybenzene), toluene, xylene, and mesitylene; alcohols such as 2-methyl-1-butanol, 4-methyl-2-pentanol, and methyl isobutyl carbinol; esters such as ethyl lactate, propylene glycol methyl ether acetate (PGMEA, commercially available from the Dow Chemical Company as Dowanol^{™} PMA), methyl 2-hydroxyisobutyrate, methyl 3-methoxypropionate and 3-methoxy-1-butyl acetate; lactones such as gamma-butyrolactone; lactams such as N-methylpyrrolidinone; ethers such as propylene glycol methyl ether and dipropylene glycol dimethyl ether isomers (commercially available from The Dow Chemical Company as Proglyde^{™} DMM); ketones such as cyclohexanone and methylcyclohexanone; and mixtures thereof.

In some non-limiting embodiments of the compositions disclosed herein, the solvent is present at an amount of 0 to 80 wt%, based on the total composition of the formulation. In some non-limiting embodiments 20 to 70 wt%, in some non-limiting embodiments 30 to 65 wt%, and in some non-limiting embodiments 45 to 60 wt%. In some non-limiting embodiments of the compositions disclosed herein, the composition comprises a single organic solvent. In some non-limiting embodiments of the compositions disclosed herein, the composition comprises two organic solvents. In some non-limiting embodiments of the compositions disclosed herein, the composition comprises three organic solvents. In some non-limiting embodiments of the compositions disclosed herein, the composition comprises four or more organic solvents. For compositions disclosed herein comprising two or more organic solvents, the relative amounts of each solvent may be about equal to one another or one solvent may be present in a greater amount. For compositions disclosed herein comprising three or more organic solvents, the relative amounts of each solvent may be about equal to one another or one solvent may be present in a greater amount than the other two. For compositions disclosed herein comprising three or more organic solvents, the relative amounts of each solvent may be about equal to one another or one solvent may be present in a greater amount than the other three. Those having skill in the art will appreciate that the specific solvent or solvents chosen, and their respective relative amounts, can be chosen based on the reaction and final-properties of interest in a given embodiment of the formulations as disclosed here.

The present invention further provides a composition comprising the composition as disclosed herein and one or more optional additives. Suitable optional additives useful in the present compositions include, without limitation, one or more of each of curing agents, surfactants, crosslinkers different from the present monomers, inorganic fillers, organic fillers, plasticizers, adhesion promoters, metal passivating materials, leveling agents, and the like, and combinations of any of the foregoing. Suitable surfactants are well-known to those skilled in the art, and in some non-limiting embodiments the surfactants are nonionic. Such surfactants may be present in an amount of from 0 to 10 wt%, based on the total solid composition of the formulation, in some non-limiting embodiments 0 to 5 wt%, in some non-limiting embodiments 0 to 2 wt%, and in some non-limiting embodiments 0 to 1 wt%. Non-limiting example of surfactants which may find use in the present compositions include adhesion promoters selected from the group consisting of silane coupling agents such as 3-[3-(Triethoxysilyl)-propylcarbamoyl]acrylic Acid; SH 6040, Dow Corning Toray; OFS-6075 Silane, Dow Corning; and 09324, Fluka. Non-limiting example of leveling agents which may find use in the present compositions include L-7604, Dow Corning Toray, Niax silicone L-5420, Momentive Performance Materials; and POLYFOX PF-656 (2234AM), OMNOVA Solutions Inc. Such leveling agents may be present in an amount of from 0 to 10 wt%, and in some non-limiting embodiments 0 to 5 wt%, and in some non-limiting embodiments 0 to 2 wt%, and in some non-limiting embodiments 0 to 1 wt%.

Any suitable inorganic fillers may optionally be used in the present compositions, and are well-known to those skilled in the art. Exemplary inorganic fillers include, but are not limited to, silica, silicon carbide, silicon nitride, alumina, aluminum carbide, aluminum nitride, zirconia, and the like, and mixtures thereof. The inorganic filler may be in the form of a powder, rods, spheres, or any other suitable shape. Such inorganic filler may have any suitable dimensions. Inorganic filler may be used in an amount of from 0 to 80 wt%, based on the total weight of the composition. Any crosslinking monomers that are different from the monomers of the invention may be used as crosslinkers, provided that they crosslink with the arylcyclobutene polymer in the composition under the conditions used to cure the composition. Suitable crosslinkers include, but are not limited to, polyamines, polythiols, and (meth)acrylatecontaining crosslinkers. The selection of such crosslinkers is within the ability of those skilled in the art. Such crosslinkers are typically used in an amount of from 0 to 20 wt%, and preferably 0 to 10 wt%, based on the total weight of the polymerizable components in the composition. One or more non-crosslinking monomers may also be added to the present compositions and are typically present in an amount of from 0 to 20 wt%, based on the total weight of the polymerizable components in the composition. Such non-crosslinking monomers contain 1 or 2 polymerizable moieties capable of polymerizing with the benzocyclobutene-based components in the present compositions. In some non-limiting embodiments, the metal passivating material is a copper passivating agent. Suitable copper passivating agents are well known in the art and include imidazoles and benzotriaoles.

The present invention further provides a cured film prepared from polymerizing and curing the composition disclosed herein. Non-limiting, specific embodiments for the cured film are the same as those identified in the context of the composition from which it is made as disclosed herein. The cured film can be prepared by polymerizing and curing the present composition on any suitable substrate, and then peeling off the cured film from the substrate. Any hard substrates having smooth surfaces can be used. Examples of the substrates can include, but are not limited to, silicon, FR-4 board, BT resin, KAPTON^{™} polyimide film, III-V semiconductor wafer such as GaN, GaAs and InP, metals, plastics, glass including fused silica, BOROFLOAT^{™} and EAGLE^{™} glass from Schott and Corning respectively, ceramics, woods, and the like. The cured film can have a refractive index that is determined by the specific composition and process steps (polymerizing and curing) used to prepare it. In some non-limiting embodiments, the refractive index of the cured films as disclosed herein is 1.3-2.0; in some non-limiting embodiments 1.4- 1.7; and in some non-limiting embodiments 1.5-1.6.

Other properties of interest in electronic and optical applications of the cured films disclosed herein include surface roughness (Rₐ), unexposed film thickness loss (UFTL), and others. The balance between such sometimes-competing properties can dictate optimum compositions and other parameters for specific end-uses of the compositions, films, articles and other items as disclosed herein. The surface roughness, Rₐ, of a film can lead to a perceived haze if it is above a certain measure for specific applications, particularly optical applications. Surface roughness can be measured by, for example, a laser scanning confocal microscope. One non-limiting example of such a device is the Keyence VK-X200 3D Laser Scanning Confocal Microscope. Surface roughness values of the cured films disclosed herein are generally measured on a unit-µm scale or tenths-µm scale. In some non-limiting embodiments of the cured films disclosed herein, the surface roughness of the film is less than 2 µm, in some non-limiting embodiments less than 1.8 µm, in some non-limiting embodiments less than 1.6 µm, in some non-limiting embodiments less than 1.4 µm, in some non-limiting embodiments less than 1.2 µm, in some non-limiting embodiments less than 1.0 µm, in some non-limiting embodiments less than 0.8 µm, in some non-limiting embodiments less than 0.6 µm, in some non-limiting embodiments less than 0.4 µm, in some non-limiting embodiments less than 0.2 µm, and in some non-limiting embodiments less than 0.1 µm. In some non-limiting embodiments, the surface roughness is between 0 and 0.2 µm, in some non-limiting embodiments between 0 and 0.18 µm, in some non-limiting embodiments between 0 and 0.16 µm, in some non-limiting embodiments between 0 and 0.14 µm, in some non-limiting embodiments between 0 and 0.12 µm, and in some non-limiting embodiments between 0 and 0.10 µm.

The unexposed film thickness loss, UFTL, of a film is also referred to as the "dark loss" and refers to the removal of the resin at the area with no light radiation. A high UFTL may impart severe top loss and reduce the aspect ratio of the film after the development cycle. This is not economically favorable, as the removed resins do not contribute to the overall function of the film in the optical or electronic devices made therewith. Unexposed film thickness loss can generally be measured by any number of microscopic techniques that are recognized by those having skill in the art as being capable of measuring film thicknesses. Non-limiting examples of such microscopic techniques include optical microscopy, electron microscopy, and atomic force microscopy. One non-limiting example of such an optical microscopic device is the Filmetrics F50. Unexposed film thickness loss values of the cured films disclosed herein may be measured as a percentage of the total film thickness that *does not* exhibit the desired optical or electronic properties for the application of interest. They may also be measured and reported as the raw value of the thickness loss in appropriate units, for example µm. In some non-limiting embodiments of the cured films disclosed herein, the unexposed film thickness loss is less than 90%, in some non-limiting embodiments less than 80%, in some non-limiting embodiments less than 70%, in some non-limiting embodiments less than 60%, in some non-limiting embodiments less than 50%, in some non-limiting embodiments less than 40%, in some non-limiting embodiments less than 30%, in some non-limiting embodiments less than 20%, in some non-limiting embodiments less than 10%, in some non-limiting embodiments less than 5%, in some non-limiting embodiments between 5% and 20%, and in some non-limiting embodiments between 8% and 15%.

The present invention further provides a method of manufacturing a film on a substrate comprising: providing a substrate; coating a layer of the composition described above on a surface of the substrate; and curing the coating layer. The substrate can be glass, an organic polymer layer, or combination thereof. The organic polymer layer can be a polyimide layer, or a clear polyimide layer. In one embodiment, the display substrate is clear polyimide layer. Non-limiting, specific embodiments for the method are the same as those identified in the context of the cured film and the composition from which it is made as disclosed herein.

The present compositions may be coated on a substrate by any suitable method. Suitable methods for disposing the present compositions include, but are not limited to, spin-coating, curtain coating, spray coating, roller coating, dip coating, vapor deposition, and lamination such as vacuum lamination, among other methods. In the semiconductor manufacturing industry, spin-coating is a preferred method to take advantage of existing equipment and processes. In spin-coating, the solids content of the composition may be adjusted, along with the spin speed, to achieve a desired thickness of the composition on the surface it is applied to. Typically, the present compositions are spin-coated at a spin speed of 400 to 4000 rpm. The amount of the present compositions dispensed on the wafer or substrate depends on the total solids content in the composition, the desired thickness of the resulting layer, and other factors well-known to those skilled in the art. When a film or layer of the present compositions is cast, such as by spin-coating, much (or all) of the solvent evaporates during deposition of the film. Preferably, after being disposed on a surface, the composition is heated (baked) to remove any remaining solvent. Typical baking temperatures are from 90 to 160 °C, although other temperatures may be suitably used. Such baking to remove residual solvent is typically done for approximately 2 minutes, although longer or shorter times may suitably be used. The arylcyclobutene oligomers are typically cured by heating for a period of time. Suitable curing temperatures range from 180 to 250 °C or higher. Typically curing times range from 1 to 600 minutes.

In an alternate method, the present compositions may be formed as a dry film and disposed on the surface of a substrate by lamination. A variety of suitable lamination techniques, including vacuum lamination techniques, may be used and are well known to those skilled in the art. In forming a dry film, the present compositions are first disposed, such as coated, onto a front surface of a suitable film support sheet such as a polyester sheet, preferably polyethyleneterephthalate (PET) sheet, or a polyimide sheet such as KAPTON^{™} polyimide, using slot-die coating, gravure printing, or another appropriate method. The composition is then soft baked at a suitable temperature, such as from 90 to 140 °C, for an appropriate time, such as from 1 to 30 minutes, to remove any solvent. A polymer film cover sheet such as polyethylene is then rolllaminated at room temperature onto the dried composition to protect the composition during storage and handling. To dispose the dried composition onto the substrate, the cover sheet is first removed. Then, the dried composition on the support sheet is laminated onto the substrate surface using roll-lamination or vacuum lamination. The lamination temperature can range from 20 to 120 °C. The support sheet is then removed (peeled), leaving the dried composition on that surface.

The present invention further provides an optical waveguide wherein the optical waveguide comprises the cured film described above. Non-limiting, specific embodiments for the optical waveguide are the same as those identified in the context of the method, the cured film, and the composition from which it is made as disclosed herein. A variety of optical waveguide structures and materials are known to those with skill in the art. They are generally configured with a core and a cladding, wherein the cladding is typically comprised of an upper cladding and a lower cladding. In operation, light enters the core from a connected optical fiber and is transmitted longitudinally through the core while being totally reflected at each of the interfaces between the core and the cladding. The waveguide core can have any number of shapes that are known to one having skill in the art. These shapes include circular, square, triangular, trapezoidal, and others. In one non-limiting embodiment of the present invention, the waveguide core comprises the composition and / or films as disclosed herein. In one non-limiting embodiment of the present invention, the waveguide cladding comprises the composition and / or films as disclosed herein.

The present invention further provides an opto-electronic circuit comprising an optical waveguide and a light-transmitting fiber, wherein the optical waveguide comprises a core surrounded by a cladding and wherein one or both of the core and cladding comprise the compositions and / or films as disclosed herein. In one non-limiting embodiment, the opto-electronic circuit comprises an optical waveguide wherein the core is comprised of the compositions and / or films as disclosed herein. In one non-limiting embodiment, the opto-electronic circuit comprises an optical waveguide wherein the cladding is comprised of the compositions and / or films as disclosed herein. Non-limiting, specific embodiments for the opto-electronic circuit are the same as those identified in the context of the optical waveguide, the method, the cured film, and the composition from which it is made as disclosed herein.

### EXAMPLES

The concepts described herein will be further illustrated in the following examples, which do not limit the scope of the invention described in the claims. Cyclobutarene-based polymers can be prepared, for example, as in may be found, for example, in U.S. Patent 6,361,926. Formulations were prepared by mixing the cyclobutarene-based polymers with DNQ solution, epoxy and surfactants. DNQ solution (22wt%) was prepared by dissolving DNQ in solvents mixture containing 67wt% of PGMEA, 18wt% of Proglyde DMM and 15% wt% of Anisole.

Examples 1 through 12 and Comparative Examples 1 and 2 - Formulations with Varying Amounts of Aromatic / Aliphatic Epoxy.

Comparative Example 1 - Formulations were prepared by mixing, in an amber vial, 60.14 g of cyclobutarene-based polymers (41% in Proglyde DMM), 29.22 g of DNQ solution, 9.36 g of aromatic epoxy (DIC Epiclon N-541), 1.15g of silane adhesion promoter solution (50wt% of 3-[3-(triethoxysilyl)propylcarbamoyl]acrylic acid in PGMEA) and 0.13 g of level agent (Dow Corning DCT L-7604) were added and mixed well to homogeneous solution. The solution was then filter through a 0.2-µ syringe filter.

Comparative Example 2 - Formulations were prepared by mixing, in an amber vial, 60.14g g of the cyclobutarene-based polymers (41% in Proglyde DMM), 29.22 g of DNQ solution, 9.36 g of aliphatic epoxy (Daicel Celloxide 2021P), 1.15g of silane adhesion promoter solution (50wt% of 3-[3-(Triethoxysilyl)propylcarbamoyl] acrylic acid in PGMEA) and 0.13 g of level agent (Dow Corning DCT L-7604) were added and mixed well to homogeneous solution. The solution was then filter through a 0.2-µ syringe filter.

Example 1 - Example 12 - Formulations were prepared by mixing the formulations from Comparative Example 1 and Comparative Example 2 in differing amounts. The relative amounts of aromatic and aliphatic epoxy were varied as described in Table 1.

**Table 1**

| **Example** | **Wt % Aliphatic Epoxy** | **Wt % Aromatic Epoxy** |
|---|---|---|
| Comparative 1 | 0 | 100 |
| Example 1 | 10 | 90 |
| Example 2 | 12.5 | 87.5 |
| Example 3 | 15 | 85 |
| Example 4 | 17.5 | 82.5 |
| Example 5 | 20 | 80 |
| Example 6 | 30 | 70 |
| Example 7 | 40 | 60 |
| Example 8 | 50 | 50 |
| Example 9 | 60 | 40 |
| Example 10 | 70 | 30 |
| Example 11 | 80 | 20 |
| Example 12 | 90 | 10 |
| Comparative 2 | 100 | 0 |

Film Examples 2 through 12 and Comparative Film Examples 1 and 2 - The films were prepared from the compositions in Examples 1 through 12 and from Comparative Examples 1 and 2 using the following method. A solution of adhesion promoter, DuPont AP9000C, was applied to a 20.32 cm (8-inch) silicon wafer at 2000 rpm followed by baking at 150 °C for 90 s. The prepared formulation was filtered by 0.1µm membrane, and then spin-coated on the wafer at 840 rpm for 30s. The wafer was baked on a hot plate at 100°C for 90s.

Film thickness after soft-bake was around 7~9 µm. Following soft-bake, the wafer was placed in a 2.38% tetramethylammonium hydroxide (TMAH) puddle for 60s to develop the film. The developed film was cured at 250°C for 1h in a Blue M oven with a nitrogen purge to keep the oxygen level lower than 100ppm.

To evaluate the film quality, the film thickness was measured using a Filmetrics F50, the surface roughness was measured using a Keyence VK-X200 3D Laser Scanning Confocal Microscope, and the refractive index was measured at 1320nm using a Metricon. The surface roughness measurement was made approximately 8.89 cm (3.5 inches) from the center of each wafer to allow a consistent comparison between examples. The results are summarized in Table 2 and plotted in Figure 1.

**Table 2**

| Example | Relative wt% of the aliphatic epoxy | thickness after soft-bake (µm) | thickness loss after developing(µm) | UFTL | Surface roughness Ra (µm) | RI @1320nm |
|---|---|---|---|---|---|---|
| Comp. 1 | 0% | 8.9 | 0.85 | 9.6% | 1.331 | 1.56404 |
| 1 | 10% | 8.75 | 0.97 | 11.1% | 0.669 | 1.56191 |
| 2 | 12.5% | 9.63 | 1.16 | 12.1% | 0.210 | 1.56107 |
| 3 | 15% | 9.53 | 1.08 | 11.3% | 0.203 | 1.56061 |
| 4 | 17.5% | 9.49 | 1.12 | 11.8% | 0.263 | 1.56028 |
| 5 | 20% | 8.54 | 1.1 | 12.9% | 0.178 | 1.56029 |
| 6 | 30% | 8.8 | 1.21 | 13.8% | 0.161 | 1.55827 |
| 7 | 40% | 8.19 | 1.46 | 17.8% | 0.219 | 1.55671 |
| 8 | 50% | 7.96 | 1.87 | 23.5% | 0.205 | 1.55492 |
| 9 | 60% | 7.81 | 2.27 | 29.1% | 0.201 | 1.55310 |
| 10 | 70% | 7.65 | 2.63 | 34.4% | 0.193 | 1.55113 |
| 11 | 80% | 7.44 | 3.3 | 44.4% | 0.220 | 1.54985 |
| 12 | 90% | 7.33 | 3.97 | 54.2% | 0.163 | 1.54812 |
| Comp. 2 | 100% | 7.14 | 5.84 | 81.8% | 0.177 | NA |

In Comparative Example 1, containing only aromatic epoxy, haze is observed after developing. When 10% of the aromatic epoxy is replaced with aliphatic epoxy, the haze is reduced, but still observed. In Example 2, with 12.5% aliphatic epoxy, the haze is completely removed. Surface roughness measurements demonstrate a similar result, where the arithmetic average roughness Rₐ is reduced from 1.3 µm with 100% aromatic epoxy (Comparative Example 1) to ~0.2 µm with greater than about 12.5% aliphatic epoxy loading (Examples 2-9). Conversely, when the formulation contains 100% aliphatic epoxy (Comparative Example 2), the UFTL is -82%. This is an indication that 82% of the resin used to formulate the film is wasted. That number quickly drops to 54% once 10% aromatic epoxy is added into the formulation (Example 9) and is further reduced to <20% as the aromatic epoxy content is further increased (Examples 1-4).

Fig. 1 illustrates film surface roughness (Rₐ) and unexposed film thickness loss (UFTL) as a function of epoxy content for films prepared from the compositions disclosed herein and as reported in Table 2. Both surface roughness and UFTL have a non-linear correlation with the aliphatic/aromatic epoxy loading.

Note that not all of the activities described above in the general description or the examples are required, that a portion of a specific activity may not be required, and that one or more further activities may be performed in addition to those described. Still further, the order in which activities are listed are not necessarily the order in which they are performed.

In the foregoing specification, the concepts have been described with reference to specific embodiments. However, one of ordinary skill in the art appreciates that various modifications and changes can be made without departing from the scope of the invention as set forth in the claims below. Accordingly, the specification and figures are to be regarded in an illustrative rather than a restrictive sense, and all such modifications are intended to be included within the scope of invention.

Benefits, other advantages, and solutions to problems have been described above with regard to specific embodiments. However, the benefits, advantages, solutions to problems, and any feature(s) that may cause any benefit, advantage, or solution to occur or become more pronounced are not to be construed as a critical, required, or essential feature of any or all the claims.

It is to be appreciated that certain features are, for clarity, described herein in the context of separate embodiments, may also be provided in combination in a single embodiment. Conversely, various features that are, for brevity, described in the context of a single embodiment, may also be provided separately or in any subcombination. Moreover, when broader and narrower ranges are disclosed, it is within the contemplation of this invention to match a minimum value from one range with a maximum value from another range and vice versa.

## Claims

1. A composition comprising: (a) one or more curable cyclobutarene-based polymers or oligomers comprising acid functional pendant groups; (b) one or more aromatic epoxy compounds comprising a mixture of glycidyl ethers of aromatic phenols; (c) one or more aliphatic epoxy compounds; and (d) one or more photoactive compounds.

2. The composition of claim 1, wherein the one or more curable cyclobutarene-based polymers or oligomers comprises as polymerized units one or more arylcyclobutene first monomers and one or more second monomers having one or more acid moieties chosen from carboxylic acid, protected carboxylic acid, and sulfonic acid.

3. The composition of claim 2, wherein the one or more arylcyclobutene first monomers has formula (1): 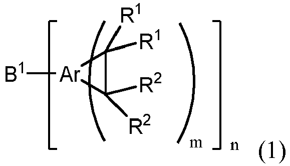 wherein B¹ is an n-valent linking group, Ar is a polyvalent aryl group that optionally contains D, m is an integer greater than or equal to 1, n is an integer greater than or equal to 1, and each of R¹ and R² is independently a monovalent group.

4. The composition of claim 2, wherein the one or more second monomers having one or more acid moieties chosen from carboxylic acid, protected carboxylic acid, and sulfonic acid has formula (4): 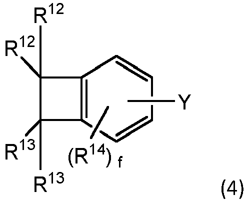 wherein each R¹² and R¹³ is independently chosen from H, D, C₁₋₆ alkyl, C₁₋₆ alkenyl, C₁₋₆ alkoxy, deuterated C₁₋₆ alkyl, deuterated C₁₋₆ alkenyl, deuterated C₁₋₆ alkoxy, halo, carboxy, C₂₋₆ carboxy-containing moiety, C₂₋₆ keto-containing moiety, C₁₋₆ amido-containing moiety, C₂₋₆ alkoxyalkanol, C₂₋₆ alkoxyester, -O-C₁₋₂₀ alkyl, -(C=O)-C₁₋₂₀ alkyl, -O-(C=O)-C₁₋₂₀ alkyl, - (C=O)-O-C₁₋₂₀ alkyl, -O-C₆₋₂₀ aryl, -(C=O)-C₆₋₂₀ aryl, -O-(C=O)-C₆₋₂₀ aryl, and -(C=O)-O-C₆₋₂₀ aryl, or deuterated versions thereof; R¹⁴ is independently chosen from H, D, C₁₋₆ alkyl, tri-C₁₋₆alkylsilyl, C₁₋₆ alkoxy, deuterated C₁₋₆ alkyl, deuterated tri-C₁₋₆-alkylsilyl, deuterated C₁₋₆ alkoxy, and halo; Y is -SO₃R¹⁵ or a monovalent radical having from 3 to 15 carbon atoms and having at least one -OH moiety or a protected carboxyl moiety; R¹⁵ is H, D or a monovalent radical having from 1 to 20 carbon atoms; and f is an integer of 3.

5. The composition of claim 1, wherein the one or more aliphatic epoxy compounds is selected from the group consisting of cyclohexane dimethanol epoxy resins, neopentyl glycol diglycidyl ethers, dicyclopentadiene type epoxy resins, hydrogenated epoxy resin, cycloaliphatic epoxy resins, polyol type epoxy resins; aliphatic ester epoxy resins, and monofunctional reactive diluent types.

6. The composition of claim 5, wherein the relative wt% of the one or more aliphatic epoxy compounds to the total wt% of the one or more aromatic epoxy compounds comprising a mixture of glycidyl ethers of aromatic phenols and the one or more aliphatic epoxy compounds is 10 to 80%.

7. A cured film prepared from polymerizing and curing the composition of claim 1.

8. The cured film of claim 7, wherein the cured film has a refractive index of 1.5 to 1.6 as measured in the specification, and a surface roughness less than or equal to 0.4 µm as measured by a laser scanning confocal microscope.

9. A method of manufacturing a film on a substrate comprising: providing a substrate and disposing a coating layer of the composition of claim 1 on a surface of the substrate; and curing the coating layer.

10. An optical waveguide wherein the optical waveguide comprises a cured film prepared from polymerizing and curing a composition comprising: (a) one or more curable cyclobutarene-based polymers or oligomers comprising acid functional pendant groups; (b) one or more aromatic epoxy compounds comprising a mixture of glycidyl ethers of aromatic phenols; (c) one or more aliphatic epoxy compounds; and (d) one or more photoactive compounds.

11. The optical waveguide of claim 10; wherein the optical waveguide comprises a core comprising a cured film prepared from polymerizing and curing a composition comprising: (a) one or more curable cyclobutarene-based polymers or oligomers comprising acid functional pendant groups, (b) one or more aromatic epoxy compounds comprising a mixture of glycidyl ethers of aromatic phenols, (c) one or more aliphatic epoxy compounds, and (d) one or more photoactive compounds; and a cladding that may be the same or different at each occurrence, wherein the cladding comprises an upper cladding and a lower cladding comprising a cured film prepared from polymerizing and curing a composition comprising: (a) one or more curable cyclobutarene-based polymers or oligomers comprising acid functional pendant groups, (b) one or more aromatic epoxy compounds comprising a mixture of glycidyl ethers of aromatic phenols, (c) one or more aliphatic epoxy compounds, and (d) one or more photoactive compounds.

## Patentansprüche

1. Zusammensetzung umfassend (a) ein oder mehrere aushärtbare Polymere oder Oligomere auf Cyclobutarenbasis, die saure, funktionelle Seitengruppen umfassen; (b) eine oder mehrere aromatische Epoxyverbindungen, die eine Mischung von Glycidylethern aromatischer Phenole umfassen; (c) eine oder mehrere aliphatische Epoxyverbindungen; und (d) eine oder mehrere photoaktive Verbindungen.

2. Zusammensetzung nach Anspruch 1, wobei das eine oder die mehreren aushärtbaren Polymere oder Oligomere auf Cyclobutarenbasis als polymerisierte Einheiten ein oder mehrere erste Arylcyclobutenmonomere und ein oder mehrere zweite Monomere umfassen, die einen oder mehrere saure Anteile aufweisen ausgewählt unter Carbonsäuren, geschützten Carbonsäuren und Sulfonsäuren.

3. Zusammensetzung nach Anspruch 2, wobei das eine oder die mehreren ersten Arylcyclobutenmonomere die Formel (I) aufweisen: 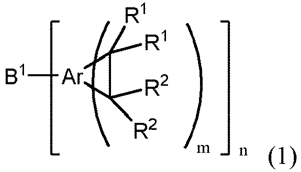 wobei B¹ eine n-wertige Verknüpfungsgruppe ist, Ar eine mehrwertige Arylgruppe ist, die wahlweise D enthält, m eine ganze Zahl von mehr als oder gleich 1 ist, n eine ganze Zahl von mehr als oder gleich 1 ist und jedes von R¹ und R² unabhängig eine einwertige Gruppe ist.

4. Zusammensetzung nach Anspruch 2, wobei das eine oder die mehreren zweiten Monomere, die einen oder mehrere saure Anteile aufweisen ausgewählt unter Carbonsäure, geschützter Carbonsäure und Sulfonsäure, die Formel (4) aufweisen: 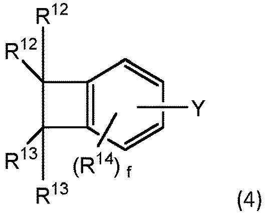 wobei jedes R¹² und R¹³ unabhängig ausgewählt wird unter H, D, C₁₋₆-Alkyl, C₁₋₆-Alkenyl, C₁₋₆-Alkoxy, deuteriertem C₁₋₆-Alkyl, deuteriertem C₁₋₆-Alkenyl, deuteriertem C₁₋₆-Alkoxy, Halo, Carboxy, C₂₋₆-Carboxy enthaltendem Anteil, C₂₋₆-Keto enthaltendem Anteil, C₁₋₆-Amido enthaltendem Anteil, C₂₋₆-Alkoxyalkanol, C₂₋₆-Alkoxyester, -O-C₁₋₂₀-Alkyl, -(C=O)-C₁₋₂₀-Alkyl, -O-(C=O)-C₁₋₂₀-Alkyl, -(C=O)-O-C₁₋₂₀-Alkyl, -O-C₆₋₂₀-Aryl, -(C=O)-C₆₋₂₀-Aryl, -O-(C=O)-C₆₋₂₀-Aryl und -(C=O)-O-C₆₋₂₀-Aryl oder deuterierten Versionen davon; R¹⁴ unabhängig ausgewählt wird unter H, D, C₁₋₆-Alkyl, Tri-C₁₋₆-Alkylsilyl, C₁₋₆-Alkoxy, deuteriertem C₁₋₆-Alkyl, deuteriertem Tri-C₁₋₆-Alkylsilyl, deuteriertem C₁₋₆-Alkoxy und Halo; Y -SO₃R¹⁵ oder ein einwertiges Radikal ist, das 3 bis 15 Kohlenstoffatome aufweist und mindestens einen -OH-Anteil oder einen geschützten Carboxylanteil aufweist; R¹⁵ H, D oder ein einwertiges Radikal ist, das 1 bis 20 Kohlenstoffatome aufweist; und f eine ganze Zahl von 3 ist.

5. Zusammensetzung nach Anspruch 1, wobei die eine oder mehreren aliphatischen Epoxyverbindungen aus der Gruppe ausgewählt werden bestehend aus Cyclohexandimethanol-Epoxidharzen, Neopentylglykoldiglycidylethern, Epoxidharzen vom Dicyclopentadientyp, hydriertem Epoxidharz, cycloaliphatischen Epoxidharzen, Epoxidharzen vom Polyoltyp, aliphatischen Esterepoxidharzen und monofunktionellen reaktiven Verdünnungsmitteltypen.

6. Zusammensetzung nach Anspruch 5, wobei der relative Gewichtsprozentsatz der einen oder mehreren aliphatischen Epoxyverbindungen zum gesamten Gewichtsprozentsatz der einen oder mehreren aromatischen Epoxyverbindungen, die eine Mischung von Glycidylethern von aromatischen Phenolen umfassen, und der einen oder mehreren aliphatischen Epoxyverbindungen 10 bis 80 % beträgt.

7. Ausgehärteter Film, die durch Polymerisieren und Aushärten der Zusammensetzung nach Anspruch 1 hergestellt wird.

8. Ausgehärteter Film nach Anspruch 7, wobei der ausgehärtete Film einen Brechungsindex von 1,5 bis 1,6, wie in der Beschreibung gemessen, und eine Oberflächenrauheit von weniger als oder gleich 0,4 µm, wie durch ein konfokales Laserscanningmikroskop gemessen, aufweist.

9. Verfahren zum Herstellen eines Films auf einem Substrat, umfassend: Bereitstellen eines Substrats und Anordnen einer Beschichtungsschicht der Zusammensetzung nach Anspruch 1 auf einer Oberfläche des Substrats; und Aushärten der Beschichtungsschicht.

10. Optischer Wellenleiter, wobei der optische Wellenleiter einen ausgehärteten Film umfasst, der durch Polymerisieren und Aushärten einer Zusammensetzung hergestellt wird umfassend (a) ein oder mehrere aushärtbare Polymere oder Oligomere auf Cyclobutarenbasis, die saure, funktionelle Seitengruppen umfassen; (b) eine oder mehrere aromatische Epoxyverbindungen, die eine Mischung von Glycidylethern aromatischer Phenole umfassen; (c) eine oder mehrere aliphatische Epoxyverbindungen; und (d) eine oder mehrere photoaktive Verbindungen.

11. Optischer Wellenleiter nach Anspruch 10, wobei der optische Wellenleiter einen Kern umfasst, der einen ausgehärteten Film umfasst, der durch Polymerisieren und Aushärten einer Zusammensetzung hergestellt wird umfassend: (a) ein oder mehrere aushärtbare Polymere oder Oligomere auf Cyclobutarenbasis, die saure, funktionelle Seitengruppen umfassen; (b) eine oder mehrere aromatische Epoxyverbindungen, die eine Mischung von Glycidylethern aromatischer Phenole umfassen; (c) eine oder mehrere aliphatische Epoxyverbindungen; und (d) eine oder mehrere photoaktive Verbindungen; und eine Verkleidung, die bei jedem Auftreten gleich oder verschieden sein kann, wobei die Verkleidung eine obere Verkleidung und eine untere Verkleidung umfasst, die einen ausgehärteten Film umfasst, der durch Polymerisieren und Aushärten einer Zusammensetzung hergestellt wird umfassend: (a) ein oder mehrere aushärtbare Polymere oder Oligomere auf Cyclobutarenbasis, die saure, funktionelle Seitengruppen umfassen; (b) eine oder mehrere aromatische Epoxyverbindungen, die eine Mischung von Glycidylethern aromatischer Phenole umfassen; (c) eine oder mehrere aliphatische Epoxyverbindungen; und (d) eine oder mehrere photoaktive Verbindungen.

## Revendications

1. Composition comprenant : (a) un ou plusieurs polymères ou oligomères durcissables à base de cyclobutarène comprenant des groupes pendants fonctionnels acides ; (b) un ou plusieurs composés époxy aromatiques comprenant un mélange d'éthers de glycidyle de phénols aromatiques ; (c) un ou plusieurs composés époxy aliphatiques ; et (d) un ou plusieurs composés photoactifs.

2. Composition selon la revendication 1, dans laquelle les un ou plusieurs polymères ou oligomères durcissables à base de cyclobutarène comprennent comme motifs polymérisés un ou plusieurs premiers monomères arylcyclobutènes et un ou plusieurs seconds monomères ayant une ou plusieurs fractions acides choisies parmi l'acide carboxylique, l'acide carboxylique protégé, et l'acide sulfonique.

3. Composition selon la revendication 2, dans laquelle les un ou plusieurs premiers monomères arylcyclobutènes présentent la formule (1) : 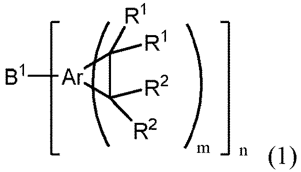 dans laquelle B¹ est un groupe de liaison n-valent, Ar est un groupe aryle polyvalent qui contient facultativement D, m est un nombre entier supérieur ou égal à 1, n est un nombre entier supérieur ou égal à 1, et chacun de R¹ et R² est indépendamment un groupe monovalent.

4. Composition selon la revendication 2, dans laquelle les un ou plusieurs seconds monomères ayant une ou plusieurs fractions acides choisies parmi l'acide carboxylique, l'acide carboxylique protégé, et l'acide sulfonique présentent la formule (4) : 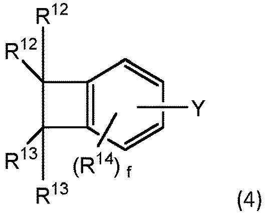 dans laquelle chacun de R¹² et R¹³ est indépendamment choisi parmi H, D, un alkyle en C₁ à C₆, alcényle en C₁ à C₆, alcoxy en C₁ à C₆, alkyle en C₁ à C₆ deutérié, alcényle en C₁ à C₆ deutérié, alcoxy en C₁ à C₆ deutérié, halogéno, carboxyle, une fraction contenant un groupe carboxyle en C₂ à C₆, une fraction contenant un groupe céto en C₂ à C₆, une fraction contenant un groupe amido en C₁ à C₆, un groupe alcoxyalcanol en C₂ à C₆, alcoxyester en C₂ à C₆, -O-(alkyle en C₁ à C₂₀), -(C=O)-(alkyle en C₁ à C₂₀), -O-(C=O)-(alkyle en C₁ à C₂₀), -(C=O)-O-(alkyle en C₁ à C₂₀), -O-(aryle en C₆ à C₂₀), -(C=O)-(aryle en C₆ à C₂₀), -O-(C=O)-(aryle en C₆ à C₂₀), et -(C=O)-O-(aryle en C₆ à C₂₀), ou leurs versions deutériées ; R¹⁴ est indépendamment choisi parmi un groupe H, D, alkyle en C₁ à C₆, tri-(alkylsilyle en C₁ à C₆), alcoxy en C₁ à C₆, alkyle en C₁ à C₆ deutérié, tri-(alkylsilyle en C₁ à C₆) deutérié, alcoxy en C₁ à C₆ deutérié, et halogéno ; Y est -SO₃R¹⁵ ou un radical monovalent ayant de 3 à 15 atomes de carbone et ayant au moins une fraction -OH ou une fraction carboxyle protégée ; R¹⁵ est un groupe H, D ou un radical monovalent ayant de 1 à 20 atomes de carbone ; et f est un nombre entier d'une valeur de 3.

5. Composition selon la revendication 1, dans laquelle les un ou plusieurs composés époxy aliphatiques sont sélectionnés dans le groupe constitué des résines cyclohexane diméthanol époxy, des éthers de diglycidyle de néopentyl glycol, des résines époxy de type dicyclopentadiène, de résine époxy hydrogénée, des résines époxy cycloaliphatiques, des résines époxy de type polyol ; des résines époxy d'ester aliphatique, et des types de diluants réactifs monofonctionnels.

6. Composition selon la revendication 5, dans laquelle le pourcentage en poids relatif des un ou plusieurs composés époxy aliphatiques au pourcentage en poids total des un ou plusieurs composés époxy aromatiques, qui comprennent un mélange d'éthers de glycidyle de phénols aromatiques, et des un ou plusieurs composés époxy aliphatiques est de 10 à 80 %.

7. Film durci préparé à partir de la polymérisation et du durcissement de la composition selon la revendication 1.

8. Film durci selon la revendication 7, dans lequel le film durci présente un indice de réfraction de 1,5 à 1,6 tel que mesuré dans la description, et une rugosité de surface inférieure ou égale à 0,4 µm telle que mesurée par un microscope confocal à balayage laser.

9. Procédé de fabrication d'un film sur un substrat comprenant les étapes consistant à : fournir un substrat et déposer une couche de revêtement de la composition selon la revendication 1 sur une surface du substrat ; et durcir la couche de revêtement.

10. Guide d'onde optique dans lequel le guide d'onde optique comprend un film durci préparé par polymérisation et durcissement d'une composition comprenant : (a) un ou plusieurs polymères ou oligomères durcissables à base de cyclobutarène comprenant des groupes pendants fonctionnels acides ; (b) un ou plusieurs composés époxy aromatiques comprenant un mélange d'éthers de glycidyle de phénols aromatiques ; (c) un ou plusieurs composés époxy aliphatiques ; et (d) un ou plusieurs composés photoactifs.

11. Guide d'onde optique selon la revendication 10 ; dans lequel le guide d'onde optique comprend un noyau comprenant un film durci préparé par polymérisation et durcissement d'une composition comprenant : (a) un ou plusieurs polymères ou oligomères durcissables à base de cyclobutarène comprenant des groupes pendants fonctionnels acides, (b) un ou plusieurs composés époxy aromatiques comprenant un mélange d'éthers de glycidyle de phénols aromatiques, (c) un ou plusieurs composés époxy aliphatiques, et (d) un ou plusieurs composés photoactifs ; et une gaine qui peut être identique ou différente à chaque occurrence, dans lequel la gaine comprend une gaine supérieure et une gaine inférieure comprenant un film durci préparé par polymérisation et durcissement d'une composition comprenant : (a) un ou plusieurs polymères ou oligomères durcissables à base de cyclobutarène comprenant des groupes pendants fonctionnels acides, (b) un ou plusieurs composés époxy aromatiques comprenant un mélange d'éthers de glycidyle de phénols aromatiques, (c) un ou plusieurs composés époxy aliphatiques, et (d) un ou plusieurs composés photoactifs.
